(19) Europäisches Patentamt
European Patent Office
Office européen des brevets

(11) Publication number: 0 222 618 A2

(12) EUROPEAN PATENT APPLICATION

(21) Application number: 86308786.2

(22) Date of filing: 12.11.86

(51) Int. Cl.4: H 01 L 21/48
H 01 L 23/52

(30) Priority: 12.11.85 US 797108 07.11.86 US 928497

(43) Date of publication of application: 20.05.87 Bulletin 87/21

(84) Designated Contracting States: AT BE CH DE ES FR GB GR IT LI LU NL SE

(71) Applicant: ENGELHARD CORPORATION
Menlo Park, CN 40
Edison New Jersey 08818 (US)

(72) Inventor: Nguyen, Pascaline
2 Tharp Lane
Marlboro New Jersey (US)

(74) Representative: Fisher, Adrian John et al
Carpmaels & Ransford 43 Bloomsbury Square
London WC1A 2RA (GB)

# (54) Multilayer hybrid integrated circuit and process for producing.

(57) The present invention is directed to a multilayer integrated circuit comprising alternating layers of conductor and dielectric formed on an insulating substrate. The conductor layers are formed by screen printing a metallo-organic composition in the desired conductor line pattern.

FIG. 4

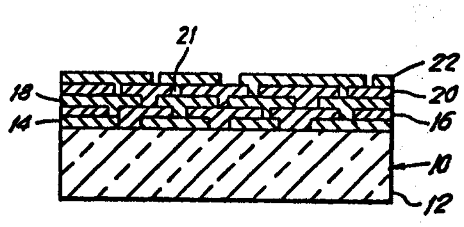


EP 0 222 618 A2

## Description

# MULTILAYER HYBRID INTEGRATED CIRCUIT AND PROCESS FOR PRODUCING

## BACKGROUND OF THE INVENTION

### I. Field of the Invention

The present invention relates to multilayer hybrid integrated circuits comprising alternating conductor and insulating layers formed on an insulating substrate and particularly to a simplified method of manufacturing such an integrated circuit.

### II. Description of the Prior Art

Multilayer hybrid integrated circuits typically comprise alternating conductor and dielectric insulating layers laminated on an insulating substrate. Each conductor layer is formed in a predetermined pattern of lines of conductor material which is dependent upon the requirements of the circuit being constructed. The conductor layers are interconnected together by means of holes, termed "via holes", that are formed in the dielectric insulating layers. The conductor layers are formed from compositions that are based on precious metal materials such as gold, copper, aluminum, platinum, palladium, silver and mixtures thereof. The dielectric insulating layers are normally formed from an insulating material such as silicon oxide, lead silicate glass or any conventional glass system used in thick film processes. More recently, polyimide materials have been used as the dielectric insulating material because they have a low dielectric constant, can form very thick layers and allow for good "via hole" resolution. This permits a large reduction in conductor line capacitance and is particularly important in those applications where a short propogation delay is an important factor in circuit design; e.g., wafer scale integration devices. As defined herein, the term "multilayer integrated circuits" includes large scale integration devices such as wafer scale integration devices and capacitors which are made up of two conductor layers and one dielectric layer.

Multilayer integrated circuits are conventionally prepared in thin film technology by a rather expensive and time-consuming process which involves sputtering and photoetching/photoresist techniques. A typical process comprises sputtering on an adhesion layer of a refractory metals such as titanium, tungsten or chromium onto the surface of a substrate such as alumina. Then, a conductive layer, for example, gold or copper is sputtered onto the adhesion layer of the substrate so as to completely coat the substrate. Thereafter, in order to form a predetermined pattern of conductor lines, the conductor layer is photoetched. The photoetching can be accomplished by either a negative working or an additive working photoresist. Such photoetching techniques are well known in the art and are described in Handbook of Thin Film Technology, Maissel, et al.

After the conductor lines are formed, a polyamic acid solution (precursor of polyimide) is spin-coated onto the substrate so as to form a layer over the conductor lines. Via hole formation in the polyimide layer is then accomplished by photoetching again using either well known negative or additive working photoresist. Subsequently, another conductive layer is sputtered onto the insulating polyimide layer. Again, photoetching is used to obtain the desired conductor line pattern. Another polyimide layer is then formed by spin-coating and photoetching is used to form the via holes. This process of forming alternating layers of conductor and dielectric is repeated until one obtains the desired number of layers. The number of alternating layers in the final integrated circuit depends on the requirements of that circuit, generally comprising 5 to 10 layers.

Such a prior art process for manufacturing multilayer hybrid integrated circuits is expensive because of the use of the sputtering techniques, which waste substantial amounts of metal. When precious metals such as gold, silver, platinum and palladium are used the sputtering process is especially wasteful and expensive because of the high cost of these materials. Moreover, because of the absolute necessity for photoetching, the prior art process can become tedious and very time consuming.

There have been some attempts to reduce the expense and to make this type of process for producing such multilayer integrated circuits less time consuming. Most of these attempts are directed to improvements in the etching process of either the polyimide insulating layer or the etching techniques employed on both the insulating and conductor layers. See, for example, U.S. Patent No. 3,575,745; 4,525,383; 4,508,479; and 3,808,049. None of these attempts, however, solve the problems of high cost and slow production speed because they still employ sputtering and photoetching techniques. The use of either one or both of these techniques must be eliminated to significantly reduce the cost and increase the production time.

One method of producing an integrated circuit, which attempts to solve this problem, comprises forming the conductor layer by screen printing a thick film conductor material onto a substrate and heat-curing it at a temperature of about 850° C. A conventional dielectric material such as a dielectric based on a glass system is screen printed on to form the dielectric layer. Alternating layers of conductor and dielectric are thereafter applied in a similar manner to obtain the multilayer integrated circuit. While this method avoids the need for sputtering and photoetching, it possesses a number of other disadvantages. Thus, the dielectric constant of the dielectric layer for standard dielectric materials is about 8 to 10. This is fairly high. While a lower dielectric constant of about 3.7 can be obtained by substituting a polyimide dielectric for the standard dielectric, the use of a polyimide dielectric would prevent the use of the thick film conductor materials. This is because in order to

cure the thick film conductors, they must be fired at a temperature of about 850°C. Firing at such a high temperature would decompose the polyimide which has a decomposition temperature of about 475°C. Accordingly, in order to use a polyimide to obtain a relatively low dielectric constant, thin film sputtering techniques, which do not require curing, must be used to apply the conductor layer. As stated above, the disadvantage of such a process for manufacturing a multilayer integrated circuit are numerous.

## SUMMARY OF THE INVENTION

The present invention is directed to a process for manufacturing multilayer integrated circuits which is relatively inexpensive, easy to employ and results in a circuit with a relatively low dielectric constant and a relatively high insulation resistance. According to the present invention, an insulating substrate is employed as the base for the multilayer integrated circuit. A metallo-organic conductor composition comprising at least one precious metal resinate, at least one base metal resinate, at least one film forming resinate and a medium is screen-printed onto the substrate so as to form the desired conductor line pattern. It is presently preferred to use a gold resinate so as to form a gold conductor line pattern. As defined herein conductor, metal resinates are those containing metals which primarily act as the conductor in the metal film after curing, whereas base metal resinates are those resinates wherein the metal oxidizes upon curing. The base metal resinates act primarily as adhesion promotors. The film forming resinates are those resinates which promote the formation of a film on the surface on which the composition is applied. Metallo-organic resinates according to the present invention are compounds comprising a central metal ion linked to ligands, such as organic and inorganic molecules, through a hetero atom bridge. The screen printed metallo-organic conductor is then dried and heat-cured, burning off the organics and leaving a metal film.

The metal film may then be built up to any desired thickness by forming a metal layer thereon. The metal layer is preferably built up by screen printing or electroplating.

Then, a dielectric layer is formed, preferably of a polyimide. The polyimide dielectric layer is either spin coated or screen printed onto the substrate over the first conductor layer. It is presently preferred to form the polyimide dielectric layer by screen printing, since such a process does not require the use of photoetching techniques to form the desired via hold pattern when via holes of 8 mils or greater are desired. In order to obtain a rheology suitable for screen printing, one or more thickeners must be added to the polyamic acid. The thickener which is added must not only result in a solution that has a rheology suitable for screen printing, it should not adversely affect the dielectric constant of the polyamic acid which is about 3.7. For this purpose, fumed silica thickeners are presently preferred and should be added in an amount of from about 0.1 to 10% by weight of the polyamic acid solution. It is desirable to maintain the dielectric constant of the polyamic acid solution below about 8, which is the dielectric constant of commercially available thick film dielectrics.

The screen printed polyamic acid is then prebaked and heat cured in an oven. As a result of the heat treatment, the polyamic acid is converted to a cured aromatic polyimide. To build up the dielectric layer additional polyamic acid may be screen printed in the same pattern on the polyimide. It is then cured and thus converted to a polyimide. The next conductor layer is normally added before final curing, the final curing taking place when the conductor layer is cured.

If spin coating is the method of application, the polyamic acid solution may be spin coated without the use of thickeners. Depending upon the viscosity of the polyamic acid solution being used, it may have to be diluted with a suitable diluent so that it can be spin coated. Also, it may be necessary to apply an adhesion promotor before spin coating. Since the thickness of the layer can be adjusted by varying the spin speed, a single coating is usually sufficient. The coated layer is then heat cured to form the polyimide. The via hole pattern may then be formed by conventional photoetching techniques. Because of the requirement for photoetching, this method of forming the dielectric layer is not the most desirable.

The next conductor layer formed from a metallo-organic conductor composition is then screen printed on in a predetermined pattern. The metallo-organic composition can either be based on the same precious metal and base metal resinates as was used to form the first conductor layer or different metal resinates. In most applications, the metallo-organic composition used to form the conductor layers in the multilayer integrated circuit will contain the same conductor metal resinate. The base metal resinates may be varied to obtain the appropriate adhesion properties depending upon the surface onto which the composition is being applied. Thus, if the substrate is different from the dielectric layer, the base metal resinates may have to be varied in amount and/or type. After the metallo-organic composition is screen printed on, it is dried and then heat-cured. This layer may also be built up to the desired thickness by forming a metal layer thereon.

Thereafter, additional alternating layers of polyimide and conductor may be added until the circuit is complete. The top layer of the completed circuit will always be a conductor layer. The number of layers of polyimide dielectric and conductor depend on the requirements of the circuit. This is also true for the types of conductor and dielectric patterns which are employed. Generally, a minimum of three conductor layers and two dielectric layers is required to form a circuit. However, a capacitor can be formed from two conductor layers and one dielectric layer.

The process of the present invention thus overcomes the disadvantages of the prior art processes by employing screen printing techniques. As a result, the time consuming and tedious photoetching and sputtering processes are not needed to obtain the desired conductor and dielectric patterns. The process is also less expensive because sputtering is not needed. The process of the present invention also has a number of other advantages over the prior art processes, including easier manufacture, good shelf life and broad

rheology capabilities.

BRIEF DESCRIPTION OF THE DRAWINGS

Fig. 1 is a sectional view showing the production of the multilayer integrated circuit of the present invention after the first production step.

Figs. 2-4 are sectional views of the multilayer integrated circuit at various stages of production.

Fig. 5 is a top view of a completed multilayer integrated circuit.

DESCRIPTION OF THE PREFERRED EMBODIMENT

The present invention will now be described in more detail with reference to the accompanying drawings. The same portions in the respective drawings are designated by the same or equivalent reference numerals.

Referring to figure 4, a hybrid multilayer integrated circuit according to the present invention is represented by reference numeral 10. It comprises an insulating substrate 12, a first conductor layer 14, an insulating dielectric layer 16, and a second conductor layer 18, a second insulating dielectric layer 10 and a third conductor layer 22. While the integrated circuit shown in Fig. 4 only contains three conductor layers and two dielectric layers, it is understood that the multilayer integrated circuit according to the present invention may have any number of alternating layers of conductor and dielectric depending upon the requirements of the particular circuit being manufactured. Generally, multilayer hybrid integrated circuits contain anywhere from about five to ten layers of alternating conductor and dielectric.

Insulating substrate 12 may be formed of an inorganic oxide including ceramic based materials such as alumina and mixtures of alumina with other oxides such as boron trioxide, silicon dioxide and lead oxide, the other oxides being present in an amount of from about 0.5 to about 8 percent by weight of the substrate. Various glass materials including silicon dioxide glasses may also be used. Beryllia, porcelanized steel and preformed polyimide materials are further examples of materials used to form insulating substrate. Any suitable insulating substrate material may, however, be used including both rigid and flexible materials. It is presently preferred to use a 96% alumina substrate (4% various mixed oxides ) as the base for the multilayer integrated circuit.

According to the process of the present invention and as best shown in figure 1, conductor layer 14 is screen printed onto the substrate in a predetermined pattern by conventional screen printing techniques. While any suitable conductor material may be used. the conductor material must have a rheology suitable for screen printing and it must possess adhesion properties sufficient to enable it to be screen printed onto the substrate being used. Further, if a polyimide dielectric is being used it must be curable at a temperature not significantly higher than the decomposition temperature of the polyimide. It is presently preferred to use a metallo-organic conductor composition containing various metallo organic resinates. It is comprised of at least one precious metal resinate, one or more base metal resinates, at least one film forming resinate and a suitable medium. Metallo organic resinates according to the present invention are compounds comprising a central metal ion linked to ligands, such as organic and inorganic molecules through a hetero atom bridge. The resinates include both naturally occurring resinates (rosin) and synthetic resinates such as, for example, carboxylates have the general formula:

$$(R-\overset{O}{\overset{|}{C}}-O)_nM$$

wherein R is a hydrocarbon containing 8 to 20 carbon atoms and $M^{+n}$ is a central metal ion with valence $+n$; alcoholates having the general formula:

$$(R-C-O)_nM$$

wherein R is a hydrocarbon containing 8 to 20 carbon atoms and $M^{+n}$ is a central metal ion with valence $+n$; metal mercaptides having the formula:

$$(R-S-)_nM$$

wherein R is a hydrocarbon moiety containing 8 to 16 carbon atoms and M is a central metal ion with valence $+n$; metallo-organic compounds having two different types of ligands having the general formula:

$$(R-NH-)_1\ M\ (-O-\overset{O}{\overset{|}{C}}-R)_n$$

wherein R is a hydrocarbon moiety containing 8 to 16 carbon atoms and M is a central metal ion with valence $+n$; compounds containing aldehyde functional groups having the formula:

$$R-\overset{O}{\overset{|}{C}}-M-O-\overset{O}{\overset{|}{C}}-R$$

wherein R is a hydrocarbon moiety containing 8 to 16 carbon atoms and M is a central metal ion; and alkoxides having the formula:

$$M(OR)_n$$

wherein R is a hydrocarbon moiety containing 8 to 16 carbon atoms and M is a central metal ion with valence $+n$.

Precious metal resinates which may be used according to the present invention include gold, silver, palladium and platinum resinates and mixtures thereof. Illustrative of such precious metal resinates are gold amine 2-ethylhexoate, t-dodecyl gold mercaptide, gold lavender, silver neodecanoate and palladium neodecanoate. A gold resinate is presently preferred. The precious metal resinate is present in an amount of from about 10 to 80 percent, more preferably in an amount of about 15 to 50, even more preferably in an

amount of about 18 to 25 percent, and most preferably in an amount of 18 to 20 percent. These percentages refer to the percent of metal present in the metallo organic resinate composition.

The film forming resinate is present in an amount of from about 0.01 to 1.0 percent and preferably in an amount of from about 0.02 to 0.5 percent. A rhodium resinate such as rhodium-2-ethylhexoate and firein are examples of a film forming resinate.

Suitable base metal resinates for use in the metallo organic composition of the present invention include bismuth resinate, vanadium resinate, chromium resinate, tin resinate, silver resinate, silicon resinate, lead resinate, titanium resinate, boron resinate, tungsten resinate, copper resinate, zirconium resinate, aluminum resinate, cadmium resinate, niobium resinate, and antimony resinate.

Illustrative of such base metal resinates are lead 2-ethylhexoate, ethylhexylborate, $Al(butoxide)_3$, $Cu(neodecanoate)_2$, silicon benzoyl/2-ethylhexoate, tetrabutyl titanate, titanium neopentanoate, maganese, zinc, chromium, bismuth and silicon 2-ethylhexoates, vanadium, naphatheonate, titanium isopropylate, tungsten cyclonol and boron-2-ethylhexanoyl, chromium isopropylate, tin dibutyl neodecanoate, neobiumbutylate, silicon benzylate and chromium methyl sulfide.

The base metal resinates generally are present in an amount of about 0.5% to 10%, more preferably in an amount of about 1%-5% and most preferably in an amount of about 1.5% to 3%. Again, the percentages refer to the percent of metal present in the metallo-organic composition. The base metal resinates are mainly present to promote adhesion. Thus, the selection of the resinates to be included in the composition and their relative proportions depends on the surface onto which the metallo-organic material is to be deposited whether or not it is going to be built up to a certain thickness and, if so, the manner in which it is to be built up. Different adhesion properties are needed for different surfaces.

It is presently preferred to use a metallo-organic composition comprising about 18 percent gold resinate, 0.3 percent bismuth resinate, 0.056 percent rhodium resinate, 0.3 percent vanadium resinate, 0.02 percent chromium resinate, 0.004 percent antimony resinate, 0.39% silicon resinate, 1.0% silver resinate, and 0.36% boron resinate. The percentages refer to the percent of metal present in the metallo-organic composition. This composition is suitable for screen printing on alumina and polyimide. It is understood that there is not only one composition which may be employed for screen printing. Other combinations of resinates in other proportions will result in the proper adhesion properties.

The medium which forms the remainder of the metallo-organic composition is composed of a suitable solvent, plasticizer and/or thickener to give the metallo-organic composition the proper rheology for screen printing. Suitable solvents include terpineol, xylene, dibutyl phthalate dipentene cyclohexanone, turpentene based solvents, oils such as Amarys oil, and various phthalate esters. Suitable plasticizers include rosin esters and suitable thickeners include various resins such as urea formaldehyde and hydrocarbon resins.

The metallo organic composition is preferably prepared by mixing together the metal resinates and the medium. The composition is then heated, preferably in a steam bath, until a gel is formed. This process burns off some of the organic components to a predetermined weight. If too much of the organic components are burned off, the percent of metals will change. This will require the addition of more medium to adjust the metal content. The resultant composition is roll-milled, preferably on a three roll mill into a paste suitable for screen printing.

The conductor layer is screen printed on to a thickness of from about 0.3 $\mu$ to about 0.6 $\mu$, preferably 0.3 to 0.5 $\mu$. After the composition is screen printed on the substrate, it is dried and then heat cured. In so doing, the medium and the organic part of the resinates is burned off leaving a metal film. While any suitable drying and heat curing technique may be employed, it is presently preferred to dry the screen printed metallo-organic conductor material at 125° C for 10 minutes and then fire it at 850° C during a 10 minute peak in a half hour firing procedure. The firing is preferably performed in a moving belt furnace. While the screen printing of only conductor line patterns has been discussed, resistors may also be screen printed as part of the conductor line pattern.

If desired and depending upon the application, the conductor layer 14 may be built up to any desired thickness, preferably about 1 to 25, more preferably 4 to 12. While any suitable conductive material may be employed, it is preferred to employ a precious metal material which is most preferably the precious metal used in the metallo organic composition. It is presently preferred to build up the layer by either screen printing or electroplating.

If screen printing is the method used to build up layer 14, it is presently preferred to employ a gold paste or ink composition of suitable rheology. Other conductor materials such as silver, platinum, palladium or mixtures thereof may also be employed. The composition generally comprise 30 to 90 percent conductor material in the form of powder and/or flakes and about 10 to 70 percent medium, more preferably 30 to 80 percent conductor material and 20 to 70 percent medium.

Suitable mediums include the mediums disclosed above for use in forming the metallo organic composition. Once layer 14 is built up in this manner layer 14 is again dried and fired. It is presently preferred to dry the screen printed material in an oven at 125°C for about 20 minutes and then fire it for one half hour with a peak temperature of 850° C for 10 minutes. The firing is preferably performed in a moving belt furnace similar to the furnace used to cure the metallo organic layer.

According to another embodiment of the present invention, layer 14 may be built up by pattern plating. This is accomplished by either plating directly onto layer 14.

Conventional electroplating techniques may be used to build up layer 14. While any conductive material can

be employed, it is presently preferred to electroplate a precious metal material, preferably the precious metal used in the metallo organic composition used to form layer 14. Gold is presently preferred. Suitable plating baths include cyanide gold plating baths such as Engelhard E56 pure gold plating bath, Engelhard E59 neutral soft gold plating bath and Technic Corporation OROTEMP-24 gold plating bath. Non-cyanide gold plating baths may also be employed.

As best shown in Fig. 2, the next step in the process involves the application of a layer of dielectric material 16. The dielectric material, preferably a polyimide, can be applied by either spin coating or screen printing it onto the substrate. Although, other suitable application methods may be used. Moreover, different methods of application may be used to form different dielectric layers of the integrated circuit. The polyimide which is used according to the present invention is in the form of polyamic acid solution which contains polyamic acid and a suitable solvent such a N-methyl pyrolidone. It is presently preferred to use a polyamic acid solution produced by Amoco Corp. called AI 830 polyamic acid solution. The polyamic acid solution may also be formed by adding a polyamic acid resin to a solvent such as N-methyl pyralidone. Other suitable forms of polyamic acid which can be screen printed may also be employed. When the polyamic acid solution is cured, it is converted to an aromatic polyimide according to the following reaction:

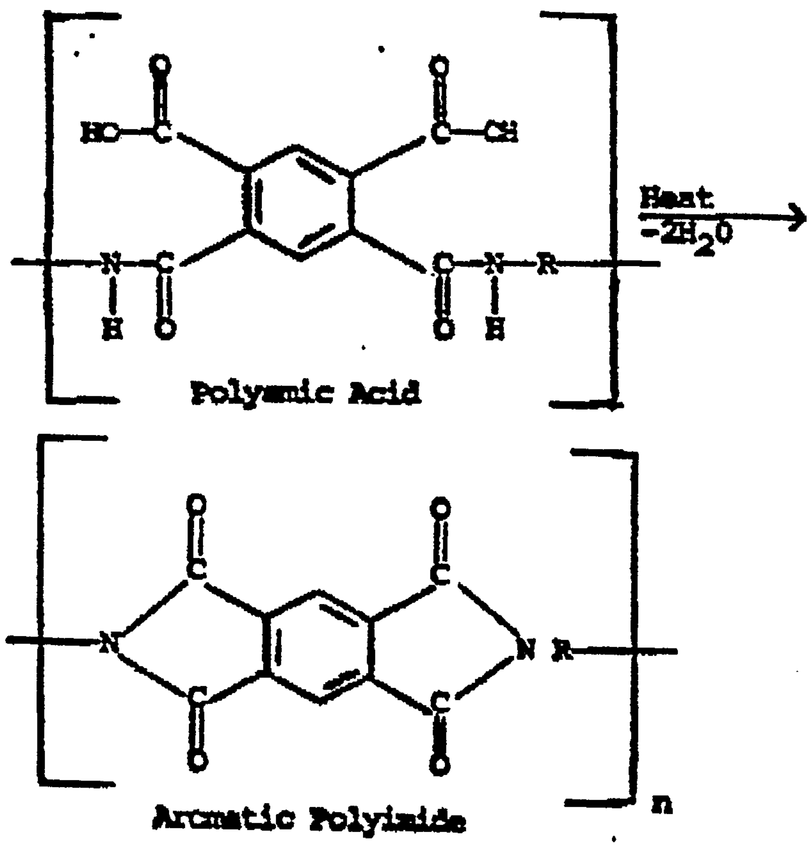


Polyamic Acid

Aromatic Polyimide

It is presently preferred to form the dielectric layer and via hole pattern therein by screen printing. In order to carry out this process the polyamic acid solution must be modified to make it suitable for screen printing while at the same time not adversely affecting the dielectric constant of the polyimide which is about 3.7. It has been found that this can be accomplished by adding one or more thickeners in an amount of up to about 20 percent by weight of the composition and preferably in an amount of about 0.1 to 10 percent by weight of the composition. Suitable thickeners include fumed silica such as Cab-O-Sil produced by Cabot Corp., a clay material such as Bentone 27 produced by NL Chemicals, a polyacrylic resin such as Acryloyd produced by Rohm Haas, an epoxy resin such as Epanol Resin, produced by Shell Chemical Corp. It is presently preferred to employ a fumed silica thickener in an amount of from about 0.1 to 10 percent by weight of the composition. The polyimide layer formed from a polyamic solution containing this thickener has a dielectric constant of about from 3.75 to 8, preferably about 3.75 to 5.0.

After the polyamic acid solution containing the thickener is screen printed on so as to form the desired via hole pattern the layer is cured by preferably baking it in an oven at about 130° for about 30 minutes. The dielectric layer which is formed has a thickness of from about 3 μ to 5 μ. If desired, the polyimide layer can be built up by screen printing the polyamic acid solution containing a suitable thickener in the same via hole pattern. The layer is preferably built up from about 7 μ to 14 μ. After screen printing that layer, it is prebaked preferably at a temperature of about 130° for about 30 minutes. It is presently preferred to screen print two

layers so as to obtain a thickness of from about 7 μ to about 14 μ. After prebaking the polyimide by heating at 130°, one can either (1) apply the next conductor layer, and then cure the polyimide by fast firing it for 10 minutes at 475°C in a fast firing furnace or (2) it can be cured at 250°-300°C for one hour, the next layer of conductor 18 applied followed by final curing at 475°C for 10 minutes or final curing at about 250°C for about thirty minutes. It is understood that any acceptable curing technique may be employed.

If spin coating is the method of application, a solution of polyamic acid without any added thickeners is spin coated on to a thickness of from about 1 μ to 5 μ, preferably from about 2 μ to 4 μ. Depending upon the polyamic acid solution which is being used, it may be necessary to apply an adhesion promotor such as, for example, Dupont's adhesion promotor VM651 prior to spin coating. It may also be necessary to add a diluent such as N-methyl pyrolidone. If Amoco's AI-380 polyamic acid solution is employed neither the adhesion promotor nor the diluent need be added. The thickness of the coating can be controlled by adjusting the spin speed. For example, to obtain a coating of about 4 μ a spin speed of about 2,000 rpms for 20 seconds should be used. Accordingly, it is not usually necessary to build up the layer by performing additional spin coatings. The spin coated polyamic acid is then prebaked, preferably at a temperature of about 130°C for 30, minutes. In order to obtain the desired via hole pattern in the polyimide layer conventional photoetching techniques using photoresist are employed. After the via hole patterns are formed, the polyimide may be finally cured, preferably at 300°C for about one hour resulting in a layer of polyimide.

The spin coating technique described above is not, however, the most desirable technique for applying the polyimide according to the present invention since it requires the time consuming and tedious photoetching techniques for forming the via hole patterns. While a process employing the spin coating technique together with the screen printing of the conductor is still a marked improvement over the prior art processes which employ sputtering and photoetching techniques for forming the conductor line patterns, a technique wherein the polyamic acid is applied by screen printing so as to form the via hole pattern is presently preferred.

Next, as best shown in Fig. 3, a conductor layer 18 is applied to the dielectric layer 16. It is applied according to the same screen printing technique as disclosed previously with reference to conductor layer 14. The pattern in which it is printed depends again on the requirements of the multilayer integrated circuit being manufactured. The conductor layer is preferably formed from a metallo-organic composition having the same conductor metal resinate as the composition used to form layer 14. Although, compositions containing different conductor metal resinates may be employed. As previously disclosed, the remainder of the metallo-organic composition may be composed of the same components as the components of the metallo-organic composition used to form layer 14 or may be composed of different components depending upon the adhesion properties necessary to obtain bonding to the polyimide layer. As disclosed above, the common way to vary adhesion properties is to vary the amounts and types of base metal resinates being employed. The same or similar medium may be employed. The conductor layer 18 may be built up to a desired thickness as previously disclosed by, for example, screen printing or electroplating.

If the polyimide layer is formed by spin coating the metallo-organic conductor layer 18 after being screen printed is dried at preferably 125°C for preferably about 10 minutes and then fast fired at 475°C for 10 minutes in moving belt furnace or cured at 250°-300°C for one hour in a box furnace. This layer and all subsequent layers of conductor are fast fired or current at temperatures of about or less than 475°C because the polyimide decomposes at higher temperatures. As described previously, if the polyimide layer is applied by screen printing the metallo-organic material may be screen printed onto the polyimide before final curing and then cured by preferably fast firing at 457°C for 10 minutes. If the conductor layer is built up by screen printing it can be dried and fast fired or cured as described in connection with the base layer 18 of metallo organic conductor material. It is understood, however, that any suitable curing techniques may be employed so long as the polyimide layer is not decomposed.

As shown in Fig. 4, another dielectric layer 20 and conductor layer 22 are then formed by the same techniques as described with reference to dielectric layer 16 and conductor layer 18. A top view of the circuit is depicted in Fig. 5 showing the conductor line pattern 22 on the dielectric layer 20. Depending on the requirements of the integrated circuit being manufactured, more alternating layers of dielectric, preferably polyimide, and conductor can be formed by the same processes as described herein with reference to conductor layers 14 and 18 and dielectric layer 16. The top layer of the finished multilayer integrated circuit will be a conductor layer.

EXAMPLE 1

A metallo-organic gold composition was produced by mixing together the following components in the following amounts: 1g vanadium resinate (4.69% vanadium), 0.2g chromium resinate (9.58% chromium), 0.2g antimony resinate (1.5% antimony), 0.5g bismuth resinate (26.91% bismuth), 0.3g rhodium resinate (15% rhodium), 51.4g gold resinate (28% gold), and a medium comprising 15g cyclopentadiene in terpineol, 22g methyl eter rosin, 6g alkyd resin and 6g ureaformaldehyde resin. The mixture is gelled in a steam bath for 3 1/2 hours at 130°C until a stiff gel is formed. During gelling, the mixture is cooked down from 102.6g to 80.4g and then roll milled on a three roll mill resulting in a paste composition of 80.0g. To 8.51g of that paste was added 0.4g silver resinate (25% silver), 0.04g bismuth resinate (26.91% bismuth), 0.3g vanadium resinate (4.69% vanadium), 0.15g silicon resinate (9.35% silicon) and 0.6g boron resinate (1.55% boron) resulting in 10g of paste which was roll milled and ready for screen printing.

The metallo-organic composition was then screen printed onto a 96% alumina substrate in a predetermined

conductor line pattern using a stainless steel screen (325 mesh size) and a 1 mil stainless steel emulsion manufactured by Microcircuit Engineering. The conductor layer had a thickness of about 0.3 μ. The substrate was then dried in an oven at 125° C for 10 minutes and then fired at 850° C during a 10 minute peak in a half hour firing procedure. The firing was performed in a moving belt furnace. A solution of polyamic acid was then prepared by adding 0.01g of a fumed silica thickener Cab-O-Sil to 9.99g Amoco's AI 830 polyamic acid solution. It was then passed through a Hoover mill and ready for screen printing. It was then screen printed on the substrate forming the predetermined via hole pattern using a 325 mesh screen and 1 mil silicon elastomer emulsion manufactured by Microcircuit Engineering. The polyimide was then prebaked in an oven at 130° C for 30 minutes. The layer was about 5 μ thick.

Another layer of polyimide was then screen printed on in the same via hole pattern to form a layer of polyimide which has a combined thickness of about 12. The polyimide was prebaked by heating at 130° C for 30 minutes. Another conductor layer was then formed by screen printing the same metallo-organic composition as previously described in a predetermined conductor line pattern. The screen printing method was as previously described. The conductor layer and the polyimide layer were then cured by fast firing at 475° C for 10 minutes. Four more layers of alternating polyimide and conductor were then formed using the same compositions and techniques as previously described. The conductor and polyimide layers were cured by fast firing at 475° C for 10 minutes. The resulting multilayer integrated circuit was then tested for dielectric constant and insulation resistance. The dielectric constant was measured at 4.1 and the insulation resistance was measured at $10^{11}$ ohm-cm.

EXAMPLE 2

A multilayer integrated circuit was formed from the same metallo-organic composition as described in Example 1 and by the same screen printing techniques as described in Example 1 except that the polyamic acid solution contained 10% Cab-O-Sil. The dielectric constant of the completed circuit was measured as 4.64 and the insulation resistance was measured at $10^{11}$ ohm-cm.

EXAMPLE 3

A multilayer integrated circuit was formed from the same metallo-organic composition as described in Example 1 and by the same screen printing techniques as described in Example 1 except that the polyamic acid solution contained 1% Bentone. The dielectric constant of the completed circuit was measured as 4.5 and the insulation resistance was measured at $10^{12}$ ohm-cm.

EXAMPLE 4

A multilayer integrated circuit was formed by the same metallo-organic composition as described in Example 1 and by the same screen printing techniques as described in Example 1 except that the polyamic acid solution contained 10% Epanol. The dielectric constant of the completed circuit was measured as 5.3 and the insulation resistance was measured at $10^{11}$ ohm-cm.

EXAMPLE 5

A multilayer integrated circuit was formed from the same metallo-organic composition as described in Example 1 and by the same screen printing techniques as described in Example 1 except that the polyamic acid solution contained 1% Acryloyd. The dielectric constant of the completed circuit was measured as 3.8 and the insulation resistance was measured at $10^{12}$ ohm-cm.

EXAMPLE 6

A multilayer integrated circuit was formed from the same metallo-organic composition as described in Example 1. However, the dielectric polyimide layer was formed by spin coating. This was accomplished by spin coating Amoco's AI 830 polyamic acid solution onto the substrate at a spin speed of about 2000 rpms for 20 seconds. The resulting layer was about 2 thick. After the spin coating was completed, the polyamic acid was prebaked at 90° C for 15 minutes and then at 130° C for one half hour. Thereafter, the via hole pattern in the polyimide layer was formed by conventional photoetching techniques using photoresist. After the via hole patterns were formed, the polyimide was finally cured at 300° C for about one hour. All three layers of polyimide were formed by this technique. The conductor layers were formed in the same manner as described in Example 1. The dielectric constant of the completed circuit was measured as 3.75 and the insulation resistance was measured at $10^{13}$ ohm-cm.

EXAMPLE 7

A multilayer integrated circuit was formed from the same metallo-organic composition as described in Example 1 and by the same screen printing techniques as described in Example 1 except that the polyamic acid solution contained 0.5% Cab-O-Sil. The dielectric constant of the completed circuit was measured as 6.4 and the insulation resistance was measured at $10^{11}$ ohm-cm.

EXAMPLE 8

A multilayer integrated circuit was formed from the same metallo-organic composition as described in Example 1 and by the same screen printing techniques as described in Example 1 except that the polyimide

solution contained 2.5% Cab-O-Sil. The dielectric constant of the completed circuit was measured as 6.7 and the insulation resistance was measured at $10^{11}$ ohm-cm.

EXAMPLE 9

A multilayer integrated circuit was formed from the same metallo-organic composition as described in Example 1 and by the same screen printing techniques as described in Example 1 except that the polyamic acid solution was composed of 10% Cab-O-Sil. The dielectric constant of the completed circuit was measured as 4.6 and the insulation resistance was measured at $10^{11}$ ohm-cm.

EXAMPLE 10

A multilayer integrated circuit was formed from the same metallo-organic composition as described in Example 1 and by the same screen printing techniques as described in Example 1 except that the polyamic acid solution was composed of 7.5% Cab-O-Sil. The dielectric constant of the completed circuit was measured as 5.3 and the insulation resistance was measured at $10^{11}$ ohm-cm.

**Claims**

1. A process for producing a multilayer hybrid integrated circuit comprising: (1) forming a first conductor layer on an insulating substrate, said conductor layer being formed by screen printing a metallo-organic composition onto the substrate in a predetermined conductor line pattern; (2) forming a first dielectric insulating layer on the substrate over the first conductor layer, said dielectric layer having a predetermined pattern of via holes for interconnecting the first conductor layer to a second conductor layer; (3) thereafter forming a second conductor layer by screen printing a metallo-organic composition on the substrate on said dielectric layer in a predetermined conductor line pattern.
2. A process according to Claim 1, wherein said dielectric insulating layer is formed by screen printing a solution comprising polyamic acid.
3. A process according to Claim 2, wherein the formation of the dielectric insulating layer includes the curing of the polyamic acid so as to form an aromatic polyimide.
4. A process according to Claim 3, wherein the solution of polyamic acid comprises polyamic acid and a thickener in an amount sufficient to make the polyamic acid solution suitable for screen printing.
5. A process according to Claim 4, wherein the thickener is selected from a group consisting of fumed silica, polyacrylic resin and epoxy resin.
6. A process according to Claim 1, wherein the metallo-organic composition comprises a conductor metal resinate selected from the group consisting of gold, silver, platinum and palladium resinates and mixtures thereof and a medium.
7. A process according to Claim 1, wherein the dielectric insulating layer is formed by spin coating polyamic acid.
8. A process according to Claim 1, wherein the integrated circuit has a dielectric constant of from about 3.7 to 8.
9. A process according to Claim 1, additionally comprising forming two additional layers of polyimide and two additional layers of conductor, said additional layers together with said first and second conductor layers and said first dielectric layer being alternately disposed; said conductor layers being formed by screen printing a metallo-organic composition.
10. A process according to Claim 9 wherein the additional layers of polyimide are being formed by screen printing.
11. A multilayer hybrid integrated circuit comprising an insulating substrate, a first conductor layer formed by screen printing a metallo-organic composition onto the substrate, a first polyimide dielectric layer formed by screen printing a solution of polyamic acid onto the substrate over the first conductor layer, said dielectric layer having via holes for interconnecting the first and a second conductor layer; and a second conductor layer formed by screen printing a metallo-organic composition onto the first polyimide layer.

0222618

FIG. 1

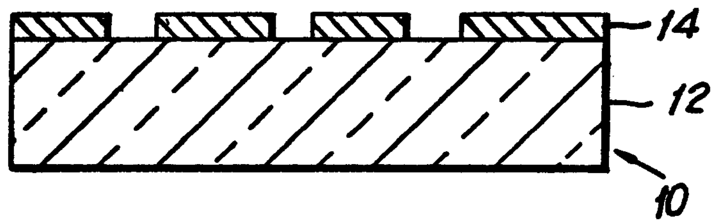


FIG. 2

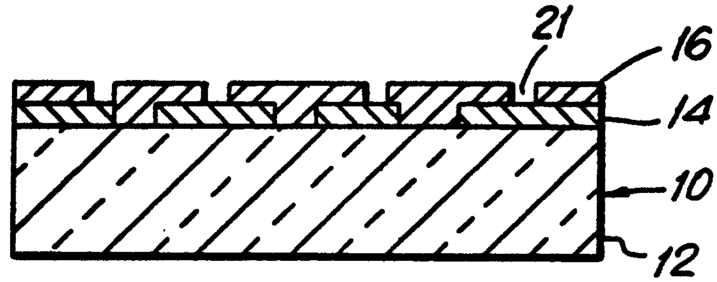


FIG. 3

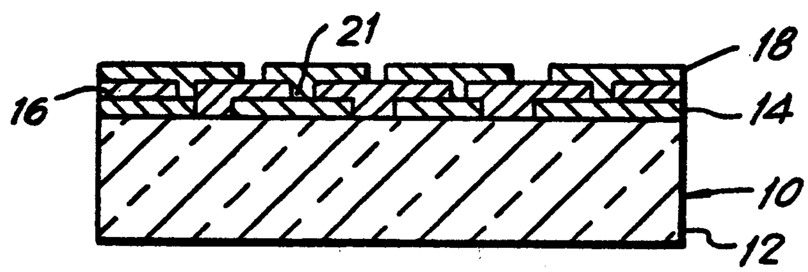


FIG. 4

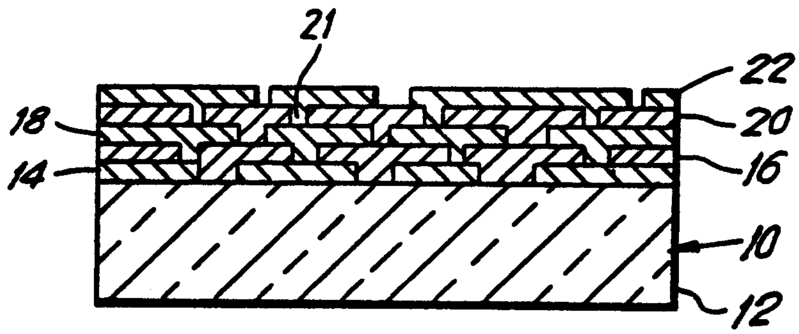

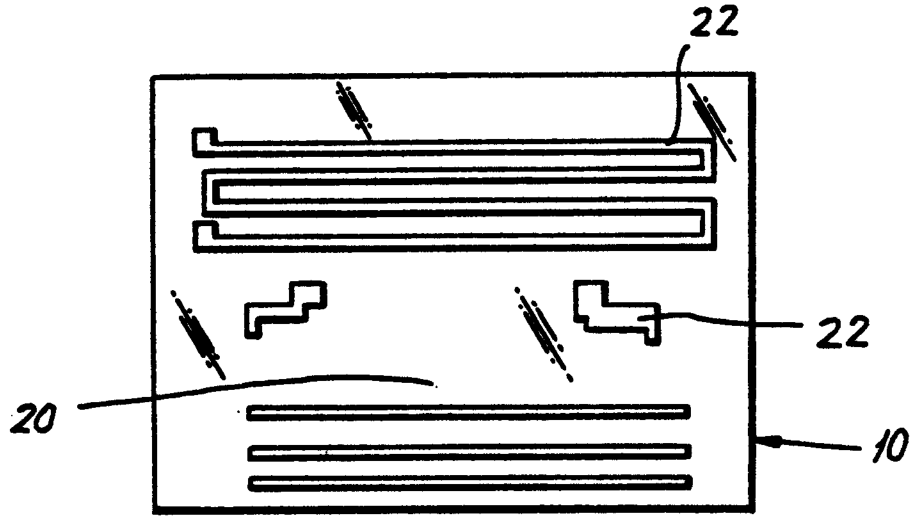


FIG. 5